(19) **Europäisches Patentamt**
**European Patent Office**
**Office européen des brevets**

(11) **EP 0 990 291 B1**

(12) **EUROPEAN PATENT SPECIFICATION**

(45) Date of publication and mention
of the grant of the patent:
**06.01.2010  Bulletin 2010/01**

(51) Int Cl.:
***H02H 3/02*** *(2006.01)*

(21) Application number: **99915791.0**

(86) International application number:
**PCT/FI1999/000318**

(22) Date of filing: **20.04.1999**

(87) International publication number:
**WO 1999/054976 (28.10.1999 Gazette 1999/43)**

(54) **METHOD FOR ADAPTING A PROTECTIVE RELAY TO THE MAINS FREQUENCY, AND A PROTECTIVE RELAY**

VERFAHREN ZUR ANPASSUNG EINES SCHUTZRELAIS AN DIE NETZFREQUENZ, UND EIN SCHUTZRELAIS

PROCEDE POUR ADAPTER UN RELAIS DE PROTECTION A LA FREQUENCE DU SECTEUR, ET RELAIS DE PROTECTION

(84) Designated Contracting States:
**DE FR GB**

(30) Priority: **21.04.1998  FI 980876**

(43) Date of publication of application:
**05.04.2000  Bulletin 2000/14**

(73) Proprietor: **ABB Oy**
**00380 Helsinki (FI)**

(72) Inventors:
• **KUISTI, Harri**
**FIN-02720 Espoo (FI)**

• **LEHTINEN, Reijo**
**FIN-33100 Tampere (FI)**

(74) Representative: **Peltonen, Antti Sakari et al**
**Kolster Oy Ab**
**Iso Roobertinkatu 23**
**P.O. Box 148**
**00121 Helsinki (FI)**

(56) References cited:
**JP-A- 1 202 114     JP-A- 3 230 722**
**JP-A- 4 058 714     JP-A- 6 311 633**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

This invention relates to a method for adapting a protective relay to the mains frequency, which method comprises the steps of claim 1 and a protective relay comprising means according to claim 4.

In general, the mains frequency equals fairly accurately the nominal frequency, which in Europe, for instance, is 50 Hz. That is why relay protection used for protecting electric networks is often mainly designed for a specific frequency. However, the frequency may considerably deviate from the nominal frequency as regards time and location, and hence the operational accuracy of the relay protection may decrease substantially. Frequency deviations are at their greatest in connection with generators supplying the network, during their start-up, when they are not yet connected to the network. The frequencies may then deviate in the order of tens of hertz, but the relay protection should operate accurately, however. Also, when the network power balance fluctuates, it is sometimes necessary to divide the network into sections whose frequencies may deviate from nominal. Also in these cases, the frequencies may deviate several hertz.

In one known method that is disclosed in EP 325 786, a protective relay is adapted to a changing mains frequency by adjusting the physical sampling frequency of an analog-to-digital converter (A/D converter) used for sampling in such way that the number of samples per AC and voltage cycle remains the same. Then for instance, a discrete Fourier transformation (DTF) gives an accurate value, the number of samples per cycle being assumed constant. The method based on changing the physical sampling frequency requires more electronic components and consequently a more complicated device, and thus the costs of the protective relay increase unnecessarily. All AD converters are not even capable of changing the physical sampling frequency dynamically.

Another known method is based on keeping the physical sampling frequency constant and changing the number of samples used in DFT while the mains frequency varies, in the manner disclosed in EP 801 745. Thus, when the mains frequency changes, the number of samples per network cycle changes, the sampling frequency being constant. A disadvantage with the method is that the mains frequency is seldom such that the number of samples per cycle were an integer, which leads to inaccurate measurement results and undesired oscillation.

BRIEF DESCRIPTION OF THE INVENTION

The object of this invention is to provide a method which avoids the above-mentioned disadvantages, and enables adaptation of a protective relay to the mains frequency in a more reliable manner and with simpler equipment. This object is achieved with the method of the invention, comprising the steps of claim 1.

The method of the invention is based on the idea that the virtual samples, whose number per network cycle is made to remain constant, are determined on the basis of the physical samples. Consequently, further operations, such as DFT, can be performed on the virtual samples by assuming that the number of samples per cycle is constant.

An advantage with the method of the invention is that the number of samples per cycle is made to remain constant also when the mains frequency changes, without a more complicated device implementation related to the changing of the physical sampling frequency. Moreover, the constant number of samples in one cycle ensures good operating accuracy of the protective relay.

The invention also relates to a frequency-adaptive protective relay comprising means according to claim 4.

BRIEF DESCRIPTION OF THE DRAWINGS

In the following the invention will be described in greater detail in connection with preferred embodiments with reference to the accompanying drawings, wherein

Figure 1 is a block diagram of the method of the invention, and
Figure 2 illustrates by way of example a signal that is re-sampled by the method of the invention.

DETAILED DESCRIPTION OF THE INVENTION

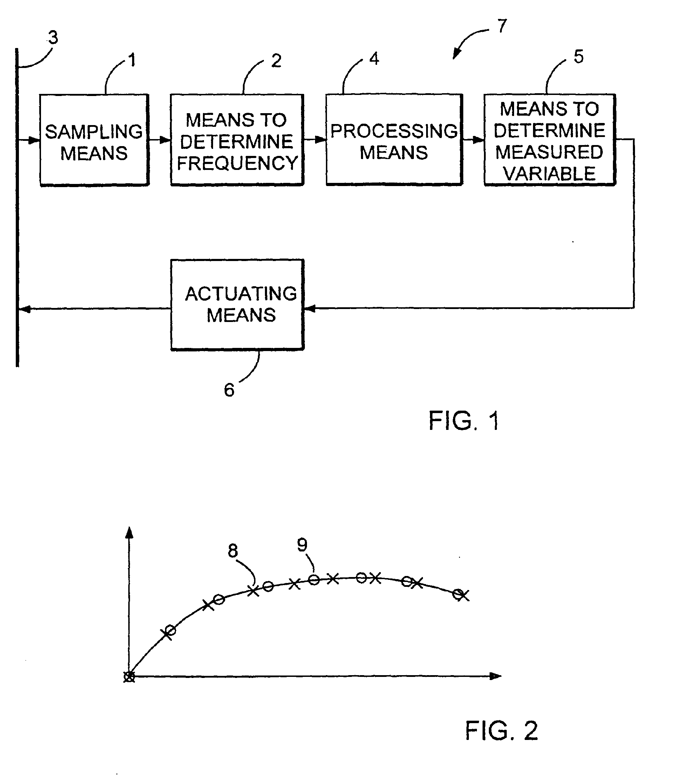

A protective relay that is divided into functional blocks in the manner illustrated in Figure 1 is connected to an electric network 3. The function of the relays is to determine the properties of specific variables in the mains, and if necessary, to perform switching operations. For instance, current or voltage of the mains can be determined. In the manner shown in Figure 1, the protective relay 7 is connected to the electric network 3, and in accordance with the method of the invention the mains frequency is determined by using a means to determine frequency 2. To determine the mains frequency, any device applicable for frequency determination can be used, given that the device is based on the measured variable or values of the measured variable provided by a sampling means. However, the method of the invention gives the best possible result when the frequency determination is as accurate as possible. In Figure 1 the means to determine frequency 2 determines the mains frequency on the basis of the samples obtained at the output of a sampling means 1.

In accordance with the method, the measured variable of mains frequency is further sampled with the sampling means 1 to provide physical samples. The sampling means takes samples with a fixed sampling frequency from the measured variable, which may be current or voltage, of the mains. The sampling means 1 may be, for instance, an A/D converter which converts an analog input signal into a digital output signal of the holding circuit at given instants of time.

In accordance with Figure 1, the output of the means to determine frequency 2 is connected to a processing means 4 which re-samples the measured variable by means of software on the basis of the physical samples received from the sampling means and provides the virtual samples. The number, per one network cycle, of virtual samples to be determined in accordance with the invention is constant. On the basis of the physical samples and the mains frequency, the processing means 4 determines the instants of time at which the virtual samples are determined. In accordance with the invention, the determination of the virtual samples is effected by interpolation on the basis of the physical samples. The simplest interpolation method is linear interpolation, whereby on the basis of two physical sample values and the instant of time, the virtual sample value is determined at a given desired instant of time. Linear interpolation can be performed, for instance, with the following formula

$$ y(j) = \left(1 - \frac{dt}{dts}\right) x(k) + \left(\frac{dt}{dts}\right) x(k+1) $$

wherein $x(k)$ and $x(k+1)$ are consecutive physical samples, between which a virtual sample $y(j)$ is located in time, dts is the time between samples in physical sampling and dt is the time distance of a virtual sample from a sample $x(k)$.

It is possible that no virtual sample falls between two consecutive physical samples. On the other hand, a plurality of virtual samples may fall between two physical samples. However, a new virtual sample is preferably calculated from the physical samples between which it will be located in time. Figure 2 illustrates by way of example a signal that has been sampled with a specific fixed sampling frequency. In Figure 2 the physical samples are indicated by circles (o) 9. In order to provide a specific constant number of samples per cycle, the signal is re-sampled, and the new virtual samples are indicated in the figure by crosses (x) 8.

The above-described linear interpolation is the simplest, but not the only possibility to determine virtual samples. The virtual samples can also be determined, for instance, by means of polynomic approximations that take into account a plurality of physical samples, whereby more accurate virtual samples can be obtained. The common characteristic of all methods used for re-sampling by means of software is that from the original physical samples they provide new virtual samples which describe the desired properties of the signal with sufficient accuracy for the use.

In accordance with the method, the virtual samples having been determined, they are further processed in a means to determine the measured variable 5. Further processing of the virtual samples refers to the operations by which the desired property is obtained from the samples. When voltage is the measured variable to be sampled, the means to determine the measured variable 5 may calculate, for instance, by a DFT transformation the amplitude of the voltage. The measured variable may also be any other property of the electric network, such as current, harmonic content of current or voltage, effective value or phase angle, or actual power, idle power, apparent power or some other derived variable such as resistance, reactance or impedance calculated from current or currents and voltage or voltages. The means to determine the measured variable may also alternatively use other calculating methods than the DFT transformation.

The means to determine the measured variable 5 is also arranged to control an actuating means 6. The control of the actuating means is performed when a characteristic, for instance voltage, of the measured variable deviates from the limits set thereto. The actuating means 6 is, for instance, a switch that is arranged to disconnect two sections of the electric network in case of a failure.

It is obvious to a person skilled in the art that as technology progresses the basic idea of the invention can be implemented in a variety of ways. Therefore, the invention and its embodiments are not restricted to the above-described examples, but they may vary within the scope of the appended claims.

**Claims**

1. A method for adapting a protective relay (7) to a mains frequency, which method comprises the steps of
   determining the mains frequency, and
   sampling a measured variable of mains frequency.to provide physical samples, determining said measured variable and performing switching operations on the basis of the determined measured variable **characterized in that** the method further comprises the steps of
   re-sampling the measured variable, by means of software, whereby mains-frequency-dependent instants of time are calculated at which virtual samples are determined, such that the number of virtual samples per network cycle is constant,
   determining the value of the measured variable at said instants of time by interpolating the virtual samples from the physical samples in order to provide virtual samples, and
   performing further processing of the measured variable on the basis of the virtual samples.

2. A method as claimed in claim 1, **characterized in that** the sampling of the measured variable of mains frequency comprises the step of determining the value of the measured variable at predetermined intervals.

3. A method as claimed in claim 1 or 2, **characterized in that** the further processing of the virtual samples comprises the step of calculating the desired property of the measured variable from the virtual samples.

4. A frequency-adaptive protective relay (7) comprising interconnected means incorporating a means to determine frequency (2) that is arranged to determine frequency of an electric network (3), a sampling means (1) that is arranged to sample a measured variable of a mains frequency and to provide physical samples, a means to determine the measured variable (5) and an actuating means (6) that is arranged to perform switching operations on the basis of the determined measured variable, **characterized in that** the protective relay (7) further comprises a data processing means (4) that is arranged to determine virtual samples on the basis of the physical samples taken from the measured variable by using interpolation, in such a way that their number per network cycle is constant, and the means to determine the measured variable (5) is arranged to determine the desired property of the measured variable on the basis of the virtual samples and to control the actuating means (6).

5. A protective relay as claimed in claim 4, **characterized in that** it comprises means arranged to determine as the desired property of the measured variable the amplitude of current or voltage.

6. A protective relay as claimed in claim 4, **characterized in that** it comprises means arranged to determine as the desired property of the measured variable the effective value of current or voltage.

7. A protective relay as claimed in claim 4, **characterized in that** it comprises means arranged to determine as the desired property of the measured variable the phase angle of current or voltage.

8. A protective relay as claimed in claim 4, **characterized in that** it comprises means arranged to determine as the desired property the amplitude of any harmonic wave of current or voltage.

9. A protective relay as claimed in claim 4, **characterized in that** it comprises means arranged to determine as the desired property of the measured variable the actual power, idle power or apparent power or some other derived variable such as resistance, reactance or impedance calculated from current or currents and voltage or voltages.

**Patentansprüche**

1. Verfahren zur Anpassung eines Schutzrelais (7) an eine Netzfrequenz, wobei das Verfahren die Schritte aufweist:

   Bestimmen der Netzfrequenz und
   Abtasten einer gemessenen Größe der Netzfrequenz zur Bereitstellung von physikalischen Proben,
   Bestimmen der besagten gemessenen Größe und
   Ausführen von Schaltvorgängen aufgrund der bestimmten gemessenen Größe, **dadurch gekennzeichnet, dass** das Verfahren weiterhin die Schritte aufweist:

   Wieder-Abtasten der gemessenen Größe anhand von Software, wobei netzfrequenzabhängige Zeitpunkte berechnet werden, zu denen virtuelle Proben bestimmt werden, so dass die Anzahl von virtuellen Proben pro Netzzyklus konstant ist,
   Bestimmen des Werts der gemessenen Größe zu den besagten Zeitpunkten, indem die virtuellen Proben aus den physikalischen Proben interpoliert werden, um virtuelle Proben bereitzustellen, und
   Ausführen einer Weiterverarbeitung der gemessenen Größe aufgrund der virtuellen Proben.

2. Verfahren nach Anspruch 1, **dadurch gekennzeichnet, dass** das Abtasten der gemessenen Größe der Netzfrequenz einen Schritt aufweist, in dem der Wert der gemessenen Größe in regelmäßigen Abständen bestimmt wird.

3. Verfahren nach Anspruch 1 oder 2, **dadurch gekennzeichnet, dass** die Weiterverarbeitung der virtuellen Proben einen Schritt aufweist, in dem die erwünschte Eigenschaft der gemessenen Größe aus den virtuellen Proben berechnet wird.

4. Frequenzadaptives Schutzrelais (7), aufweisend miteinander verbundene Mittel mit einem Mittel zur Frequenzbestimmung (2), das angeordnet ist, die Frequenz eines elektrischen Netzwerks (3) zu bestimmen, einem Abtastmittel (1), das angeordnet ist, eine gemessene Größe einer Netzfrequenz abzutasten und physikalische Proben bereitzustellen, einem Mittel zur Bestimmung der gemessenen Größe (5) und einem Betätigungsmittel (6), das angeordnet ist, Schaltvorgänge aufgrund der bestimmten gemessenen Größe auszuführen, **dadurch gekennzeichnet, dass** das Schutzrelais (7) weiterhin ein Datenverarbeitungsmittel (4) aufweist, das angeordnet ist, virtuelle Proben aufgrund der von der gemessenen Größe genommenen physikalischen Proben durch Interpolation zu bestimmen, so dass ihre Anzahl pro Netzzyklus konstant ist, und das Mittel zur Bestimmung der gemessenen Größe (5) angeordnet ist, die erwünsche Eigenschaft der gemessenen Größe aufgrund der virtuellen Proben zu bestimmen und das Betätigungsmittel (6) zu steuern.

5. Schutzrelais nach Anspruch 4, **dadurch gekennzeichnet, dass** es Mittel aufweist, die angeordnet sind, die Amplitude von Strom oder Spannung als erwünschte Eigenschaft der gemessenen Größe zu bestimmen.

6. Schutzrelais nach Anspruch 4, **dadurch gekennzeichnet, dass** es Mittel aufweist, die angeordnet sind, den Effektivwert von Strom oder Spannung als erwünschte Eigenschaft der gemessenen Größe zu bestimmen.

7. Schutzrelais nach Anspruch 4, **dadurch gekennzeichnet, dass** es Mittel aufweist, die angeordnet sind, den Phasenwinkel von Strom oder Spannung als erwünschte Eigenschaft der gemessenen Größe zu bestimmen.

8. Schutzrelais nach Anspruch 4, **dadurch gekennzeichnet, dass** es Mittel aufweist, die angeordnet sind, die Amplitude irgendeiner Oberwelle von Strom oder Spannung als erwünschte Eigenschaft der gemessenen Größe zu bestimmen.

9. Schutzrelais nach Anspruch 4, **dadurch gekennzeichnet, dass** es Mittel aufweist, die angeordnet sind, die Wirkleistung, Blindleistung oder Scheinleistung oder eine andere abgeleitete Größe wie Resistanz, Reaktanz oder Impedanz, die aus Strom oder Strömen und Spannung oder Spannungen berechnet ist, als erwünschte Eigenschaft der gemessenen Größe zu bestimmen.

**Revendications**

1. Procédé destiné à adapter un relais de protection (7) à une fréquence de secteur, lequel procédé comporte les étapes ci-après consistant à :

   déterminer la fréquence de secteur, et échantillonner une variable mesurée de fréquence de secteur pour délivrer des échantillons physiques, déterminer ladite variable mesurée et mettre en oeuvre des opérations de commutation sur la base de la variable mesurée déterminée, **caractérisé en ce que** le procédé comporte en outre les étapes ci-dessous consistant à :

   ré-échantillonner la variable mesurée, au moyen d'un logiciel, moyennant quoi des instants temporels dépendants de la fréquence de secteur sont calculés, auxquels sont déterminés des échantillons virtuels, de sorte que le nombre d'échantillons virtuels par cycle de réseau est constant ; déterminer la valeur de la variable mesurée auxdits instants temporels en interpolant les échantillons virtuels à partir des échantillons physiques en vue de délivrer les échantillons virtuels ; et mettre en oeuvre un traitement ultérieur de la variable mesurée sur la base des échantillons virtuels.

2. Procédé selon la revendication 1, **caractérisé en ce que** l'échantillonnage de la variable mesurée de fréquence du secteur comporte l'étape consistant à déterminer la valeur de la variable mesurée à des intervalles prédéterminés.

3. Procédé selon la revendication 1 ou 2, **caractérisé en ce que** le traitement supplémentaire des échantillons virtuels comporte l'étape consistant à calculer la propriété désirée de la variable mesurée à partir d'échantillons virtuels.

4. Relais de protection à fréquence adaptative (7) comportant des moyens interconnectés intégrant un moyen permettant de déterminer une fréquence (2), lequel est agencé de manière à déterminer la fréquence d'un réseau électrique (3), un moyen d'échantillonnage (1) lequel est agencé de manière à échantillonner une variable mesurée d'une fréquence de secteur et à délivrer des échantillons physiques ; un moyen permettant de déterminer la variable mesurée (5) et un moyen d'actionnement (6) lequel est agencé de manière à mettre en oeuvre des opérations de commutation sur la base de la variable mesurée déterminée, **caractérisé en ce que** le relais de protection (7) comporte en outre un moyen de traitement de données (4) lequel est agencé de manière à déterminer des échantillons virtuels sur la base d'échantillons physiques tirés de la variable mesurée au moyen d'une interpolation, de sorte que leur nombre par cycle de réseau est constant, et le moyen permettant de déterminer la variable mesurée (5) est agencé de manière à déterminer la propriété désirée de la variable mesurée sur la base des échantillons virtuels et à commander le moyen d'actionnement (6).

5. Relais de protection selon la revendication 4, **caractérisé en ce qu'**il comporte des moyens agencés de manière à déterminer, en tant que la propriété désirée de la variable mesurée, l'amplitude du courant ou de la tension.

6. Relais de protection selon la revendication 4, **caractérisé en ce qu'**il comporte des moyens agencés de manière à déterminer, en tant que la propriété désirée de la variable mesurée, la valeur réelle du courant ou de la tension.

7. Relais de protection selon la revendication 4, **caractérisé en ce qu'**il comporte des moyens agencés de manière à déterminer, en tant que la propriété désirée de la variable mesurée, l'angle de phase du courant ou de la tension.

8. Relais de protection selon la revendication 4, **caractérisé en ce qu'**il comporte des moyens agencés de manière à déterminer, en tant que la propriété désirée de la variable mesurée, l'amplitude d'une quelconque onde harmonique du courant ou de la tension.

9. Relais de protection selon la revendication 4, **caractérisé en ce qu'**il comporte des moyens agencés de manière à déterminer, en tant que la propriété désirée de la variable mesurée, la puissance en cours, la puissance au repos ou la puissance apparente ou une quelconque autre variable dérivée comme la résistance, la réactance ou l'impédance calculée à partir du courant, de courants et de la tension ou de tensions.

FIG. 1

FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 325786 A
- EP 801745 A